Europäisches Patentamt

European Patent Office

Office européen des brevets

(19)

(11) Numéro de publication: **0 241 331**
**B1**

# (12) FASCICULE DE BREVET EUROPEEN

(45) Date de publication du fascicule du brevet:
**11.07.90**

(51) Int. Cl.⁵: **H05K 3/04**, H01Q 15/00

(21) Numéro de dépôt: **87400570.5**

(22) Date de dépôt: **13.03.87**

(54) **Procédé pour la réalisation de motifs électriquement conducteurs sur une surface non développable d'un substrat isolant et dispositif obtenu.**

(30) Priorité: **19.03.86 FR 8603928**

(43) Date de publication de la demande:
**14.10.87 Bulletin 87/42**

(45) Mention de la délivrance du brevet:
**11.07.90 Bulletin 90/28**

(84) Etats contractants désignés:
**AT BE CH DE ES GB IT LI NL SE**

(56) Documents cités:
**EP-A- 0 108 254**
**DE-A- 2 334 585**
**FR-A- 1 407 752**

**IBM TECHNICAL DISCLOSURE BULLETIN,**
**vol. 13, no. 8, janvier 1971, pages 2195,2196, New York,**
**US; R.D. McNUTT: "Fine line deletion"**

(73) Titulaire: **AEROSPATIALE SOCIETE NATIONALE INDUSTRIELLE Société Anonyme dite:, 37, Boulevard de Montmorency, F-75016 Paris(FR)**

(72) Inventeur: **Clariou, Jean-Pierre, 8 rue Nicolas II, F-78600 Maisons-Lafitte(FR)**

(74) Mandataire: **Bonnetat, Christian et al, CABINET BONNETAT 23, Rue de Léningrad, F-75008 Paris(FR)**

## Description

La présente invention concerne un procédé pour la réalisation de motifs électriquement conducteurs sur une surface non développable d'un substrat isolant. Quoique non exclusivement, elle est particulièrement appropriée à la réalisation, sur un paraboloïde, d'une grille de polarisation (antenne à réutilisation de fréquence) ou d'une série de motifs résonnants (antennes dichroïques). L'invention concerne aussi les dispositifs comportant un tel substrat dont ladite surface non développable porte lesdits motifs électriquement conducteurs, réalisés conformément au procédé.

On sait que, pour réaliser un circuit imprimé sur une face plane d'un substrat électriquement isolant (voir par exemple le document FR-A 1 407 752), on commence par recouvrir uniformément ladite surface d'une couche d'un métal, tel que le cuivre ou l'aluminium, après quoi cette couche métallique est elle-même uniformément recouverte d'un produit photosensible. Ensuite, le produit photosensible est exposé à un faisceau lumineux, à travers un masque correspondant au circuit imprimé à obtenir. Une telle exposition rend chimiquement résistante les parties du produit photosensible se trouvant à l'aplomb des parties de la couche métallique devant former le circuit imprimé, de sorte qu'une attaque chimique appropriée permet ensuite d'éliminer sélectivement les portions du produit photosensible qui n'ont pas été rendues chimiquement résistantes par l'exposition, ainsi que les portions de couche métallique se trouvant sous celles-ci.

A la suite de ladite attaque chimique, on obtient donc le circuit imprimé désiré.

Dans le cas où l'on désirerait appliquer cette méthode à la réalisation de circuits imprimés sur une surface non développable, on se heurterait à des difficultés au moment de l'application du masque sur ladite surface. En effet, pour des raisons évidentes de commodité de réalisation et de précision, un tel masque est plan. Aussi, il faudrait soit découper ledit masque en pièces d'aires réduites et appliquer en les juxtaposant lesdites pièces sur ladite surface non développable, soit réaliser ledit masque en un matériau souple pouvant être appliqué par déformation sur celle-ci. Dans les deux cas, le circuit imprimé obtenu serait peu précis, aussi bien en ce qui concerne la forme que la position des motifs qui le composent.

On remarquera de plus que si, en variante, on réalise ledit circuit imprimé sur un substrat auxiliaire plan destiné à être appliqué ultérieurement sur la surface non développable, on se heurte aux mêmes difficultés que celles mentionées ci-dessus à propos des masques.

La présente invention a pour objet de remédier à ces inconvénients et de permettre de réaliser des circuits imprimés précis, directement sur des surfaces non développables.

A cette fin, selon l'invention, le procédé permettant de réaliser des motifs électriquement conducteurs sur une surface non développable d'un substrat électriquement isolant, procédé selon lequel on commence par recouvrir uniformément ladite surface d'une couche d'une matière électriquement conductrice, que l'on recouvre à son tour d'une couche d'une matière de protection, après quoi on soumet ladite couche de matière de protection et ladite couche de matière électriquement conductrice à l'action d'un agent chimique en vue d'éliminer sélectivement les portions de ladite couche de matière électriquement conductrice ne correspondant pas auxdits motifs, est caractérisé en ce que, après formation desdites couches de matière conductrice et de matière de protection, on trace mécaniquement sur celles-ci le contour desdits motifs au moyen d'un outil creusant des sillons dont la profondeur est au moins égale à l'épaisseur de ladite couche de protection, puis on soumet lesdites couches à l'action d'un agent chimique susceptible d'attaquer ladite matière électriquement conductrice sans attaquer ladite matière de protection, cette opération d'attaque chimique étant poursuivie pendant un temps suffisant pour que ladite matière électriquement conductrice soit éliminée sur toute son épaisseur à l'aplomb desdits sillons, après quoi on sépare du substrat, par pelage, les parties de ladite couche de matière électriquement conductrice extérieures auxdits motifs.

Ainsi, grâce au procédé de l'invention, on peut réaliser directement des motifs électriquement conducteurs sur des surfaces non développables sans avoir recours à un masque ou un substrat auxiliaire avec lesquels, d'ailleurs, il serait techniquement difficile d'obtenir des motifs aussi précis tant au niveau de leur forme que de leur position sur lesdites surfaces.

L'outil nécessaire au traçage des contours desdits motifs peut avantageusement être une pointe de gravure déplacée de façon à rester au moins sensiblement orthogonale auxdites couches de matière de protection et de matière conductrice. Toutefois, l'outil de gravure peut également être une lame coupante, plus particulièrement adaptée dans le cas où la trajectoire de l'outil reste sensiblement rectiligne.

La pointe de gravure permet de réaliser des contours de motifs de formes complexes.

Afin de faciliter la séparation, par pelage, des partiez de ladite couche de matière électriquement conductrice, extérieures auxdits motifs, on pratique au moins une amorce de décollement sur lesdites parties. Ensuite, on sépare, par traction, les parties de la couche conductrice extérieures auxdits motifs au moyen d'un outil de préhension saisissant lesdites amorces de décollement.

De préférence, l'agent chimique, éliminant sélectivement ladite couche de matière conductrice, peut être du perchlorure de fer, lorsque ladite couche est en cuivre, ou, de la soude, lorsque ladite couche est en aluminium.

Ladite couche de matière de protection, insensible à l'action dudit agent chimique, peut être un vernis organique, un revêtement d'oxyde ou bien encore un métal noble.

Pour la mise en œuvre du procédé, l'outil comprend avantageusement une pointe de gravure montée dans une tête par l'intermédiaire d'un coulisseau qui, d'une part, est pressé vers l'extérieur par des moyens élastiques susceptibles de se comprimer, lorsque ladite pointe est appliquée contre une surface à graver et, d'autre part, est guidé dans ses déplacements par des moyens de guidage portés sur ladite tête.

Les figures du dessin annexé feront bien comprendre comment l'invention peut être réalisée. Des références identiques désignent des éléments semblables.

Les figures 1A, 1B, 1C, 1D, 1E et 1F illustrent différentes phases du procédé selon l'invention.

La figure 2 illustre, en perspective, à l'aide d'un exemple particulier de réalisation, la phase finale du procédé selon l'invention.

La figure 3 représente, en coupe, un outil pour la mise en œuvre du procédé.

La figure 4 représente une application dudit procédé à un dispositif schématiquement illustré du type comportant un réflecteur.

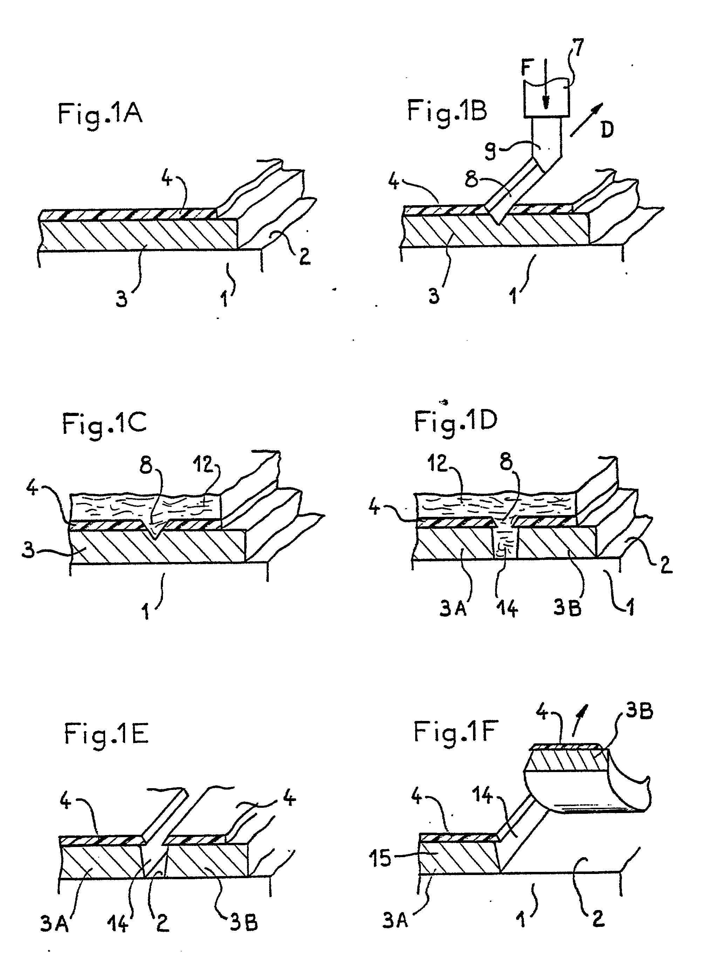

Le procédé conforme à l'invention, décrit en regard des figures 1A à 1F, est destiné à la réalisation de motifs électriquement conducteurs directement sur une surface non développable d'un substrat isolant.

Sur la figure 1A, le substrat isolant 1, représenté partiellement, est de forme quelconque, concave ou convexe, et est, par exemple, réslisé dans un matériau composite renforcé de fibres de verre ou d'aramide. Une face 2 du substrat 1 est recouverte uniformément d'une couche 3 d'une matière électriquement conductrice, par exemple métallique. A son tour, la couche 3 est recouverte d'une couche 4 de matière de protection. Le substrat 1 est ainsi revêtu, d'une première couche conductrice 3 et d'une seconde couche protectrice 4 disposée sur la première couche 3.

Selon le procédé de l'invention, on trace (figure 1B) mécaniquement sur les couches 3 et 4, le contour des motifs à obtenir au moyen d'un outil 7 creusant des sillons 8.

L'outil 7 est constitué d'une partie active, telle qu'une pointe de gravure 9, et travaille dans une direction d'effort symbolisée par une flèche F sensiblement normale aux couches 3 et 4 et ce quelle que soit la forme (paraboloïde, hyperboloïde...) dudit substrat 1. La profondeur des sillons 8, tracés par la pointe de gravure 9 de l'outil 7, est au moins égale à l'épaisseur de la couche protectrice 4. Sur la figure 1B, le sillon 8 représenté, pénètre également dans la couche conductrice 3.

La pointe de gravure 9 est réalisée dans un matériau à dureté élevée, tel qu'un carbure ou un diamant. Durant cette phase du procédé, le déplacement, symbolisé par une flèche D, et la direction d'effort F de l'outil 7 sont soigneusement définis et contrôlés afin d'obtenir un tracé aussi fin et aussi précis que possible.

Dans une variante de réalisation non illustrée, la pointe de gravure 9 pourrait être remplacée par une lame coupante, adaptée plus particulièrement dans le cas où la trajectoire de l'outil reste sensiblement rectiligne (réalisation de fils ou de bandes par exemple).

On soumet ensuite, selon le procédé de l'invention, (figures 1C et 1D), les couches protectrice 4 et conductrice 3 à l'ation d'un agent chimique 12.

Le dépôt de l'agent chimique 12 sur la couche 4 s'effectue par exemple par projection ou par trempage.

Cet agent chimique 12 attaque, à travers les sillons 8 préalablement usinés, la couche de matière électriquement conductrice 3, sans attaquer la couche de matière protectrice 4. L'agent chimique 12, éliminant alors sélectivement la couche conductrice 3, est par exemple du perchlorure de fer, lorsque la couche 3 est en cuivre, ou, de la soude, lorsque la couche 3 est en aluminium.

La couche protectrice 4, insensible à l'action de l'agent chimique 12, est constituée par exemple d'un vernis organique, d'un revêtement d'oxyde, ou encore d'un métal noble.

L'action de l'agent chimique 12 sur la couche conductrice 3 est poursuivie jusqu'à ce que celle-ci soit éliminée sur toute son épaisseur à l'aplomb des sillons 8 (figure 1D). Ainsi, ladite couche conductrice 3 comporte alors des parties 3A et 3B séparées les unes des autres par des rainures 14 en correspondance avec les sillons 8 initialement pratiqués. Les rainures 14 atteignent la face 2 du substrat composite 1, insensible à l'action dudit agent chimique 12.

A titre d'exemple, dans le cas d'une couche conductrice 3 en cuivre de 35 micromètres d'épaisseur, le temps de gravure à température ambiante à l'aide d'un agent chimique tel que du perchlorure de fer projeté sous pression est de l'ordre de 8 minutes et la largeur de la gravure ainsi obtenue, et donc des rainures 14 séparant les parties 3A et 3B, n'excède pas 100 micromètres.

Ensuite, un rinçage est effectué sur l'ensemble du substrat 1 et desdites couches 3 et 4 partiellement découpées.

La dernière phase du procédé consiste alors (figure 1F) à séparer du substrat 1, par pelage, les parties de la couche conductrice 3 extérieures aux motifs à obtenir.

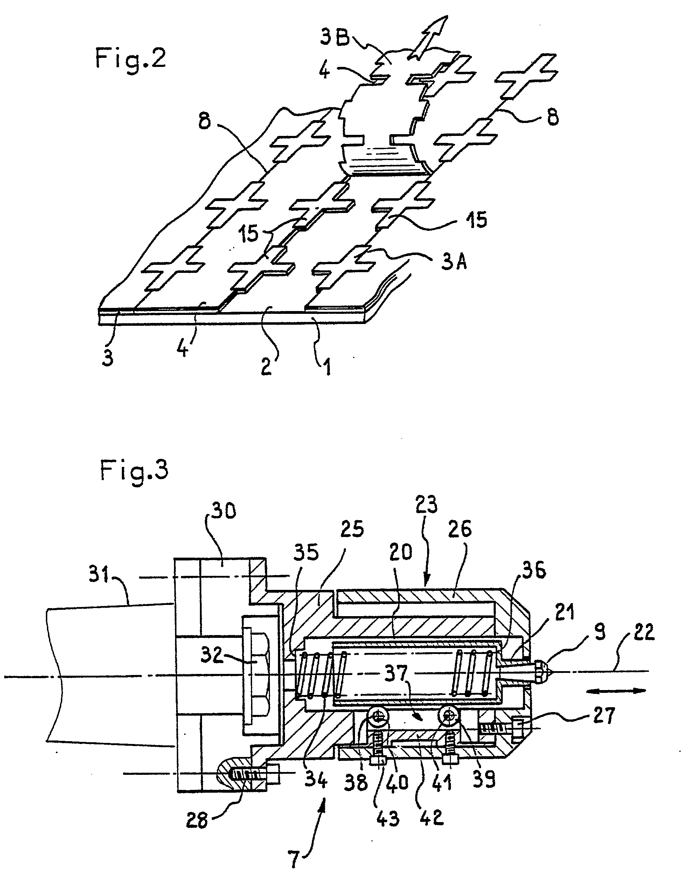

Par exemple, on retire les parties 3B de la couche 3 pour conserver les parties 3A correspondant aux motifs 15 désirés. De manière à faciliter le pelage des parties 3B, on pratique au moins une amorce de décollement (non représentée sur les figures 1F et 2) au moyen d'un outil tel qu'un grattoir, entre les parties 3B et la face 2 du substrat 1. On sépare ensuite par traction les parties 3B (revêtues de la partie correspondante de la couche 4 protectrice) de la face 2 du substrat 1, au moyen d'un outil de préhension saisissant ladite amorce de décollement. L'effort de traction exercé sur ladite couche lors de sa séparation, par pelage, du substrat au moyen de l'outil de préhension, tel qu'une pince, est maintenu inférieur à la résistance mécanique à la rupture de la couche conductrice métallique.

On élimine ainsi de façon continue les parties 3B de la face 2 du substrat 1, en évitant le risque d'écaillage. Une fois les parties 3B totalement retirées du substrat 1, il ne reste sur celui-ci que les parties 3A revêtues de la couche protectrice restante 4, et correspondant aux motifs 15 désirés.

Un exemple particulier de motifs 15 électriquement conducteurs est illustré sur la figure 2. Dans cette perspective, on retrouve le substrat 1 revêtu de la première couche conductrice 3, sur laquelle est déposée la seconde couche protectrice 4. Après la mise en oeuvre de la pointe de gravure 9 de l'outil 7, déterminant le contour des motifs 15 à obtenir par les sillons 8, et l'action de l'agent chimique 12, on retire par pelage, suivant la flèche indiquée sur la figure, les parties 3B extérieures auxdits motifs 15 à obtenir.

Les parties 3B sont recouvertes des parties correspondantes de la couche 4. On obtient alors un réseau de motifs 15, par exemple en forme de croix, en relief par rapport à la face 2 du substrat 1.

Le procédé de l'invention remédie ainsi aux inconvénients des procédés de l'art antérieur et permet de réaliser des motifs précis, par exemple de circuits imprimés, directement sur des surfaces non développables.

Un exemple de réalisation de l'outil pour la mise en oeuvre du procédé est montré, en coupe, par la figure 3.

L'outil 7 comporte un coulisseau 20, sensiblement de forme cylindrique creuse, recevant à une de ses extrémités 21, la pointe de gravure 9, par exemple taillée en prisme à 90°. Celle-ci et le coulisseau 20 présentent par exemple un axe commun 22.

Le coulisseau 20 est monté dans une tête 23 qui l'entoure et il est susceptible de se déplacer alternativement par rapport à ladite tête 23, le long de l'axe 22. Deux parties 25 et 26 composent la tête 23 et sont fixées entre elles par des vis 27. De plus, la partie 25 de la tête 23 est solidaire au moyen de vis 28, d'un adaptateur 30, lequel est relié à un cône de montage 31 d'une machine non représentée, par un écrou 32. Cette machine peut par exemple être à commande numérique.

Le coulisseau 20, portant la pointe de gravure 9, est poussé par des moyens élastiques constitués par un ressort 34, prenant appui d'une part, contre le fond 35 de la partie 25 fixe et d'autre part, contre un épaulement 36 ménagé au voisinage de l'extrémité 21 du coulisseau mobile 20. Le ressort 34 se comprime, lorsque ladite pointe de gravure 9 est appliquée contre les couches protectrice et conductrice revêtant le substrat précédemment décrits.

De plus, afin d'assurer un déplacement précis du coulisseau mobile 20 le long de l'axe 22, celui-ci est guidé dans ses mouvements alternatifs par des moyens de guidage constitués par trois jeux 37 de deux galets 38 et 39.

Ces jeux de guide 37 sont disposés à 120° l'un de l'autre autour de l'axe 22. Les galets 38 et 39 sont montés autour d'axes, respectivement 40 et 41, agencés dans un manchon 42, lequel est fixé à la partie 26 de la tête 23 au moyen de vis 43. Ainsi, le coulisseau 20 muni de la pointe de gravure 9 est pressé et guidé en direction du substrat à usiner, le ressort 34 maintenant un effort constant de la pointe de gravure sur lesdites couches 3 et 4.

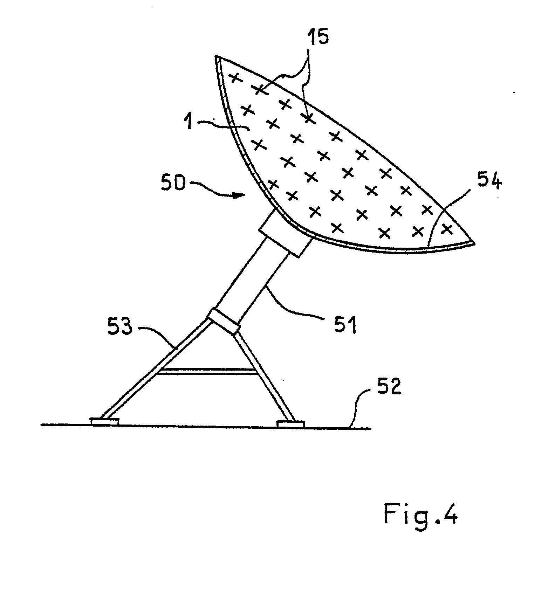

Une application du procédé de l'invention est illustrée en regard de la figure 4. Un réflecteur d'antenne 50 schématiquement représenté en coupe, est monté sur un support 51, lequel coopère avec une surface d'appui 52 par l'intermédiaire de bras 53. Le réflecteur 50 présente une surface non développable, en forme par exemple de paraboloïde 54.

Cette surface 54 porte un substrat isolant 1 pourvu d'un réseau de motifs 15 électriquement conducteurs, réalisés directement sur la surface 54 par la mise en oeuvre du procédé selon l'invention. Les motifs 15 obtenus sont par exemple ceux représentés sur la figure 2. Une telle réalisation de motifs est particulièrement adaptée aux réflecteurs dichroïques.

**Revendications**

1 - Procédé permettant de réaliser des motifs électriquement conducteurs (15) sur une surface non développable (2) d'un substrat électriquement isolant (1), procédé selon lequel on commence par recouvrir uniformément ladite surface (2) d'une couche d'une matière électriquement conductrice (3), que l'on recouvre à son tour d'une couche d'une matière de protection (4), après quoi on soumet ladite couche de matière de protection (4) et ladite couche de matière électriquement conductrice (3) à l'action d'un agent chimique (12) en vue d'éliminer sélectivement les portions de ladite couche de matière électriquement conductrice (3) ne correspondant pas auxdits motifs (15), caractérisé en ce que, après formation desdites couches de matière conductrice (3) et de matière de protection (4), on trace mécaniquement sur celles-ci le contour desdits motifs (15) au moyen d'un outil (7) creusant des sillons (8) dont la profondeur est au moins égale à l'épaisseur de ladite couche de protection (4), puis on soumet lesdites couches (3 et 4) à l'action d'un agent chimique (12) susceptible d'attaquer ladite matière électriquement conductrice (3) sans attaquer ladite matière de protection (4), cette opération d'attaque chimique étant poursuivie pendant un temps suffisant pour que ladite matière électriquement conductrice soit éliminée sur toute son épaisseur à l'aplomb desdits sillons (8), après quoi on sépare du substrat (1), par pelage, les parties (3B) de ladite couche de matière électriquement conductrice (3) extérieures auxdits motifs (15).

2. Procédé selon la revendication 1, caractérisé en ce que, comme outil (7), on utilise une pointe de gravure (9) que l'on déplace en la maintenant au moins sensiblement orthogonale auxdites couches de matière de protection (4) et de matière conductrice.

3. Procédé selon la revendication 1, caractérisé en ce que, préalablement au pelage, on pratique au moins une amorce de décollement sur les parties (3B) de ladite douche conductrice (3) extérieures auxdits motifs (15).

4. Procédé selon la revendication 3, caractérisé en ce qu'on sépare, par traction, les parties (33) de ladite couche conductrice (3) extérieures auxdits motifs au moyen d'un outil de préhension saisissant ladite amorce de décollement.

5. Procédé selon l'une des revendications 1 à 4, caractérisé en ce que l'agent chimique (12) éliminant sélectivement ladite couche de matière conductrice (3) est du perchlorure de fer, lorsque ladite couche (3) est en cuivre, ou, de la soude, lorsque ladite couche (3) est en aluminium.

6. Procédé selon l'une des revendications 1 à 5, caractérisé en ce que ladite couche de matière de protection (4), insensible à l'action dudit agent chimique (12), est un vernis organique, un revêtement d'oxyde ou bien encore un métal noble.

## Patentansprüche

1. Verfahren, welches die Herstellung von elektrisch leitfähigen Mustern (15) auf einer nicht abwickelbaren Oberfläche (2) eines elektrisch isolierenden Substrats (1) erlaubt, gemäß welchem Verfahren begonnen wird, besagte Oberfläche (2) mit einer Schichte aus einem elektrisch leitfähigen Werkstoff (3) einheitlich zu bedecken, welche ihrerseits mit einer Schichte aus einem Schutzwerkstoff (4) bedeckt wird, wonach besagte Schichte aus Schutzwerkstoff (4) und besagte Schichte aus elektrisch leitfähigem Werkstoff (3) der Wirkung eines Reagens (12) unterworfen werden, um selektiv die Abschnitte der genannten Schichte aus elektrisch leitfähigem Werkstoff (3), welche nicht den genannten Mustern (15) entsprechen, zu beseitigen, dadurch gekennzeichnet, daß nach Bildung der genannten Schichten aus leitfähigem Werkstoff (3) und aus Schutzwerkstoff (4) auf denselben die Kontur der genannten Muster (15) mittels eines Werkzeuges (7) mechanisch aufgetragen wird, welches Furchen (8) eingräbt, deren Tiefe mindestens gleich der Stärke besagter Schutzschicht (4) ist, worauf die genannten Schichten (3 und 4) der Wirkung eines Reagens (12) unterworfen werden, welches geeignet ist, den genannten elektrisch leitfähigen Werkstoff (3) anzugreifen, ohne den genannten Schutzwerkstoff (4) anzugreifen, wobei dieser Vorgang des chemischen Angreifens während einer Zeit durchgemacht wird, die ausreicht, daß besagter elektrisch leitfähiger Werkstoff über seine ganze Stärke im rechten Winkel zu besagten Furchen (8) beseitigt wird, wonach, durch Abziehen, die Partien (3B) besagter Schichte aus elektrisch leitfähigem Werkstoff (3), welche außerhalb besagter Muster (15) liegen, vom Substrat (1) getrennt werden.

2. Verfahren nach Anspruch 1, dadurch gekennzeichnet, daß als Werkzeug (7) ein Gravurstift (9) verwendet wird, der verschoben wird, wobei er zumindest annähernd im rechten Winkel zu besagten Schichten aus Schutzwerkstoff (4) und aus leitfähigem Werkstoff (3) gehalten wird.

3. Verfahren nach Anspruch 1, dadurch gekennzeichnet, daß vor dem Abziehen mindestens ein Ablöseanriß auf den außerhalb besagter Muster (15) liegenden Partien (3B) besagter leitfähiger Schichte (3) angebracht wird.

4. Verfahren nach Anspruch 3, dadurch gekennzeichnet, daß, durch Ziehen, die Partien (3B) besagter leitfähiger Schichte (3), welche außerhalb der genannten Muster liegen, mittels eines Greifwerkzeuges, welches den genannten Ablöseanriß ergreift, entfernt werden.

5. Verfahren nach einem der Ansprüche 1 bis 4, dadurch gekennzeichnet, daß das Reagens (12), welches selektiv besagte Schichte aus leitfähigem Werkstoff (3) entfernt, aus Eisenchlorid ist, wenn besagte Schichte (3) aus Kupfer ist, oder aus Soda, wenn besagte Schichte aus Aluminium ist.

6. Verfahren nach einem der Ansprüche 1 bis 5, dadurch gekennzeichnet, daß besagte Schichte aus Schutzwerkstoff (4), welche gegenüber der Wirkung des genannten Reagens (12) unempfindlich ist, ein organischer Lack, eine Oxydschicht oder ebenso ein Edelmetall ist.

## Claims

1. Process for making electrically conductive lines (15) on a non-developable surface (2) of an electrically insulating substrate (1), whereby said surface (2) is firstly uniformly coated with a layer of an electrically conductive matter (3), said layer being in turn coated with a layer of a protective matter (4), after which said layer of protective matter (4) and said layer of electrically conductive matter (3) are subjected to the action of a chemical agent (12) for the purpose of selectively eliminating those portions of said layer of electrically conductive matter (3) not corresponding to said lines (15), characterized by the following steps:
   — after formation of said layers of conductive matter (3) and of protective matter (4), mechanically tracing thereon the contour of said lines (15) by means of a tool (7) hollowing out grooves (8) of which the depth is at least equal to the thickness of said protective layer (4),
   — then subjecting said layers (3 and 4) to the action of a chemical agent (12) capable of attacking said electrically conductive matter (3) without attacking said protective matter (4), this chemical attack operation being continued for a sufficient period of time for said electrically conductive matter to be eliminated over the whole of its thickness plumb with said grooves (8),
   — thereafter separating from the substrate (1), by peeling, those parts (3B) of said layer of electrically conductive matter (3) outside said lines (15).

2. Process according to claim 1, characterized in that an engraving point (9) is used as tool (7), which is displaced whilst being maintained at least substantially orthogonal to said layers of protective matter (4) and of conductive matter (3).

3. Process according to claim 1, characterized in that, prior to peeling, at least one incipient detachment is provided on those parts (3B) of said conductive layer (3) outside said lines (15).

4. Process according to claim 3, characterized in that those parts (3B) of the conductive layer (3) outside said lines are separated, by pulling, by means of a gripping tool gripping said incipient detachment.

5. Process according to one of claims 1 to 4, characterized in that the chemical agent (12) which selectively eliminates said layer of conductive matter (3) is iron perchloride, when said layer (3) is made of copper, or soda, when said layer (3) is made of aluminium.

6. Process according to one of claims 1 to 5, characterized in that said layer of protective matter (4), insensitive to the action of said chemical agent (12), is an organic varnish, a coating of oxide or a noble metal.

Fig.1A

Fig.1B

Fig.1C

Fig.1D

Fig.1E

Fig.1F

Fig.2

Fig.3

Fig.4